# EUROPÄISCHE PATENTSCHRIFT

(11) **EP 2 401 152 B1**
(45) Veröffentlichungstag und Bekanntmachung des Hinweises auf die Patenterteilung: **03.04.2019**
(21) Anmeldenummer: 10702666.8
(22) Anmeldetag: 02.02.2010
(51) Int. Cl.: B41F 16/00, B41F 19/06, H05K 3/04

(54) **DRUCKVERFAHREN ZUR HERSTELLUNG INDIVIDUALISIERTER ELEKTRISCHER UND/ODER ELEKTRONISCHER STRUKTUREN**
PRINTING METHOD FOR PRODUCING INDIVIDUALIZED ELECTRIC AND/OR ELECTRONIC STRUCTURES
PROCÉDÉ D'IMPRESSION PERMETTANT LA PRODUCTION DE STRUCTURES ÉLECTRIQUES ET/OU ÉLECTRONIQUES INDIVIDUALISÉES

(30) Priorität: 27.02.2009 DE 102009001221
(43) Veröffentlichungstag der Anmeldung: 04.01.2012
(73) Patentinhaber: Evonik Degussa GmbH, 45128 Essen (DE)
(72) Erfinder: STEIGER, Jürgen, 40237 Düsseldorf (DE); HOPPE, Arne, 44623 Herne (DE); NETTELNBREKER, Hans-Jürgen, 45721 Haltern (DE); NIEMANN, Björn, 45665 Recklinghausen (DE); DREXLER, Adrian, 86505 Münsterhausen (DE); STOLZENBERG, Stephan, 79674 Todtnau (DE)
(86) Internationale Anmeldenummer: PCT/EP2010/051224
(87) Internationale Veröffentlichungsnummer: WO 2010/097270

(56) Entgegenhaltungen:
- EP-A2- 1 736 324
- EP-A2- 1 839 903
- US-A1- 2005 167 035

## Beschreibung

Die vorliegende Erfindung betrifft ein Druckverfahren zur Herstellung individualisierter elektrischer und/oder elektronischer Strukturen.

Bei einer elektrischen Struktur im Sinne der vorliegenden Erfindung handelt es sich dabei um eine elektrische Schaltung oder Teile einer elektrischen Schaltung, die einen Zusammenschluss mit elektrischen bzw. elektromechanischen Komponenten (wie z.B. Schaltern, Lampen oder Motoren) bilden kann oder bildet. Die Funktionsweise der Schaltung beruht dabei auf einem elektrischen Strom, der in einem geschlossenen Kreislauf (Stromkreis) durch die Bauteile fließt. Unter einer elektrischen Struktur sind dabei nicht nur aktive Elemente, sondern auch passive elektrische Elemente (wie beispielsweise Antennen oder Leiterbahnen) zu verstehen.

Bei einer elektronischen Struktur im Sinne der vorliegenden Erfindung handelt es sich dabei um eine elektronische Schaltung oder Teile einer elektronischen Schaltung, die einen Zusammenschluss mit elektronischen Bauelementen (wie z.B. Dioden, Kondensatoren und Transistoren) bilden kann oder bildet. Unter einer elektronischen Struktur sind dabei insbesondere auch leitfähige Strukturen zu verstehen, die Teil eines Kondensators sein können. Eine in der Struktur enthaltene Information, kann dabei z.B. über kapazitive Verfahren ausgelesen werden können. Derartige leitfähige Strukturen, die Teil eines Kondensators sein können, sind zum Beispiel Muster, zweidimensionale Barcodes oder auch Texte.

Die Herstellung elektronischer und/oder elektrischer Strukturen über Druckprozesse hat im Vergleich zu vielen anderen Verfahren wie z.B. Masken-Ätzen, Lithographie oder das Benutzen von Schattenmasken den Vorteil, dass die Deposition über einen kontinuierlichen Druckprozess erfolgen kann und somit vergleichsweise schneller und kostengünstiger ist. Es sind mittlerweile verschiedene Verfahren bekannt, elektrische bzw. elektronische Strukturen, insbesondere elektrische und/oder elektronische Schaltungen, ganz oder teilweise durch drucktechnische Verfahren auf ein Trägersubstrat bzw. einen Bedruckstoff zu übertragen.

Da sich über Offsetdruck sehr kleine Elemente darstellen lassen, ist dies Verfahren prinzipiell gut geeignet, elektronische Schaltungen ganz oder teilweise herzustellen. Mit der aufgrund ihrer langen Lebensdauer als "permanent" bezeichneten Druckform des Offsetdrucks kann dabei eine hohe Produktivität mit gleichzeitig sehr hohen Strukturfeinheiten erreicht werden. Da die permanente Druckform beim Offsetdruck jedoch aufgrund ihrer Komplexität und den damit verbundenen hohen Herstellkosten üblicherweise für mehr als einen Druckdurchlauf verwendet wird, hat dies Verfahren den Nachteil, dass darüber keine individualisierten elektronischen und/oder elektrischen Strukturen über eine einfache Art und Weise im Massendruck auf Trägersubstraten bzw. Bedruckstoffen aufgebracht werden können.

Unter einer "individualisierten" Struktur ist dabei eine für sich genommen einzigartige Struktur zu verstehen. Insbesondere unterscheidet sich diese individualisierte Struktur von den anderen Strukturen, die während eines zeitgleichen sowie den zeitlich davor und danach liegenden Druckdurchläufen erzeugt wird, durch eine andere zweidimensionale Ausgestaltung. Derartige individualisierte elektronische und/oder elektrische Strukturen haben gegenüber nicht individualisierten Strukturen den Vorteil, dass mit ihnen über im wesentlichen elektrischen und/oder elektronischen Verfahren eindeutig zuordnebare Informationen ausgegeben und/oder aufgenommen werden können.

Im Gegensatz zu dem Drucken reiner Texte bzw. graphisch gestalteter Strukturen kommt es beim Drucken von elektronischen und/oder elektrischen Strukturen nicht nur auf eine gute visuelle Wiedergabe sondern vor allem auf die Einhaltung der elektrophysikalischen Anforderungen an. So ist z.B. der Widerstand einer Leiterbahn nicht nur von den Materialeigenschaften des applizierten leitfähigen Materials abhängig, sondern auch von der Geometrie des Leitungsquerschnittes. Die dünnste Stelle der Leiterbahn definiert den wirksamen elektrischen Widerstand. Für eine reproduzierbare, definierte elektrische Funktion ist somit eine möglichst gleichmäßige, homogene Applikation der leitfähigen Druckfarbe notwendig.

Ein weiterer Nachteil des Offsetdrucks sind deswegen die relativ dünnen Schichten, die über Offsetdruck appliziert werden können (maximal 3 µm). Diese geringen Schichtdicken resultieren in relativ hohen Durchgangswiderständen und hohen Anfälligkeiten für drucktechnische Störungen. Auch das Wegschlagen der Druckfarbe in den Bedruckstoff kann zu Veränderungen der elektro-physikalischen Eigenschaften führen.

Diese Nachteile können zwar durch den Einsatz von modifizierten Bogenoffsetfarben, in denen Pigmente oder leitfähige Strukturen in einem Bindemittel gebunden sind, vermieden werden, die Leitfähigkeit der resultierenden Strukturen leidet aber dabei.

Eine Möglichkeit, eine hohe Produktivität und sehr hohe Strukturfeinheiten zu erhalten, dabei aber die genannten Nachteile zu umgehen, ist das Folientransferverfahren.

Ein Folientransferverfahren zur Herstellung elektronischer und/oder elektrischer Strukturen wird in DE 10 2004 019 412 A1 beschrieben. Dies Dokument beschreibt Verfahren zum Drucken elektrischer und/oder elektronischer Strukturen, insbesondere elektrischer Leiterbahnen und/oder elektronischer Schaltungen, auf einen Bedruckstoff, bei dem der Bedruckstoff hierzu durch mehrere hintereinander angeordnete Druckwerke einer Druckmaschine bewegt wird, und in mindestens einem ersten Druckwerk ein Sujet der zu druckenden elektrischen und/oder elektronischen Struktur mit einem Kleber auf den Bedruckstoff aufgetragen wird, und der mit dem Klebstoff partiell bedruckte Bedruckstoff mindestens einem zweiten Druckwerk zugeführt wird, in welchem auf die mit Klebstoff bedruckten Bereiche des Bedruckstoffs ein leitfähiges Material aufgetragen wird. Das leitfähige Material kann z.B. metallischer Art sein, oder aus leitfähigen Rußen oder Funktionspolymeren wie z.B. Polythiophenen, Polypyrrolen, Polyanilinen oder Polyethylen-Dioxythiophenen bestehen. Das Folientransferverfahren kann weiterhin inline in einer Offsetdruckmaschine erfolgen.

Bislang wird eine Individualisierung von Informationen über Druckprozesse zum Beispiel bei der Seriennummerierung von Geldscheinen oder beim Aufbringen eines Mindesthaltbarkeitsdatums auf Lebensmittelverpackungen angewandt. Technisch kommen dabei bislang unterschiedliche Verfahren zum Einsatz.

Die am häufigsten angewendete Technik ist das Stempeln von Informationen. Bei diesem Verfahren, auch "Impact Numbering" genannt, werden zum Beispiel Rotationsstempel verwendet, die fortlaufende Produktnummern auf die Bedruckstoffe aufdrucken. Alternativ können auch Laser zum Informationsübertrag eingesetzt werden. Bei dieser "Laser-Perforation" oder auch "Laser-Engraving" genannten Methode werden individualisierte Informationen auf eine spezielle lasersensitive Schicht im Bedruckstoff übertragen. Eine weitere Technik, die mittlerweile verstärkt in der Individualisierung zum Einsatz kommt, ist der individualisierte Tintenstrahldruck. Bei dieser "Inkjet-printing" genannten Methode werden kleine Tintentröpfchen auf den Bedruckstoff übertragen. Durch die Rasterung und die kleine Größe der Tropfen eignet sich diese Methode auch, bildgebende Schichten zu übertragen.

All diese Individualisierungstechniken eignen sich jedoch nicht dazu, die über ein Folientransferverfahren herstellbaren elektronischen und/oder elektrischen Strukturen über ein direktes Verfahren selbst zu individualisieren.

DE 10 2005 011 697 A1 beschreibt die Kombination eines Folientransferverfahrens mit verschiedenen Individualisierungsschritten zur Warensicherung. Dabei kann die Individualisierung in Form einer Nummerierung oder eines Strichcodes über mechanischen Druck, Inkjet-Druck, Lasergravur und ggf. auch über ein Hologramm erfolgen. Möglich ist auch eine Individualisierung über Präge- oder Struktureffekte, ein Aufbringen über radiofrequente Etiketten oder bestimmte organische Chemikalien im Kleber. Bei keiner dieser Individualisierungsmöglichkeiten handelt es sich jedoch um technische Individualisierungen der leitfähigen Struktur selbst, sondern um Individualisierungen einer selbst nicht-individualisierten Struktur über separate Hilfsmittel. In der beschriebenen Methode handelt es sich weiterhin um ein indirektes Verfahren zum Aufbringen von Informationen. Da die Individualisierung auf der Transferfolie vor dem Übertrag auf den Bedruckstoff stattfindet, hat diese Methode den Nachteil, dass sie nicht über eine befriedigende Passergenauigkeit verfügt, da die Transferfolie beim kontinuierlichen Abrollen vibriert und schwingt.

DE 10 2005 011 568 A1 beschreibt ebenfalls die Kombination von einem Folientransferverfahren mit verschiedenen Individualisierungsschriften, nämlich über mechanischen Druck, Inkjet-Druck, Lasergravur, Hologramme, die Verwendung von Präge- und Struktur-Werkzeugen oder hochfrequente Etiketten. Auch in diesem Falle erfolgt jedoch keine Individualisierung der leitfähigen Struktur selbst, sondern eine Individualisierung der nicht-individualisierten Struktur über separate Hilfsmittel.

Auch EP 1 803 562 A1 beschreibt ein Folientransferverfahren, bei dem über ein separates Inkjet-System vor oder nach der Folienapplikation ein Individualisierungsschritt durchgeführt werden kann. Somit erfolgt auch hier keine Individualisierung der leitfähigen Struktur selbst, sondern eine Individualisierung der nicht-individualisierten Struktur über ein separates Hilfsmittel.

Prinzipiell wäre zwar auch denkbar, Herstellverfahren für elektrische und/oder elektronische Strukturen über Folientransferverfahren mit angeschlossenen Inkjet-Druck-Individualisierungsschritten des o.g. Standes der Technik im Handel erhältlichen verdruckbaren Formulierungen zur Erzeugung leitfähiger durchzuführen, und so über ein kombiniertes Folientransfer-Inkjet-Verfahren (zum Beispiel über das "Schließen" von über Folientransferverfahren hergestellter Leiterbahnen via Inkjet-Druck) individualisierte elektrische und/oder elektronische Strukturen zu erzeugen. So gibt es zum Beispiel von der Firma Cabot Inkjet-Formulierungen auf Basis von Silbernanopartikeln, die nach Trocknung und gegebenenfalls einer zusätzlichen thermischen Nachbehandlung eine hohe spezifische Leitfähigkeit aufweisen. Ebenfalls ist es bekannt, dass intrinsisch leitfähige Polymere, wie zum Beispiel Pani (Polyanilin, z.B. von Ormecon) oder Clevios P (Pedot:PSS, z.B. von H.C. Starck) mit einem Digitaldruckverfahren wie z.B. Inkjet aufgebracht werden können. Von H.C. Starck gibt es beispielsweise kommerziell erhältliche leitfähige Inkjet-Tinten. Ein gemeinsamer Nachteil eines möglichen nachträglichen Individualisierungsschrittes über Inkjet-Druck ist dabei jedoch, dass diese nach einem Auftragungsschritt zumeist aufwändig getrocknet und ggf. zusätzlich thermisch nachbehandelt werden müssen. Darüber hinaus haben alle bekannten kommerziell erhältlichen Tinten den Nachteil, dass sie zum einen häufig nicht über die gewünschten physikalischen Eigenschaften wie Viskosität o.ä. verfügen, und zum anderen in der Regel sehr kostenintensiv sind.

EP 1 736 324 A2 offenbart ein Druckverfahren zur Herstellung elektrischer und/oder elektronischer Strukturen auf einem Bedruckstoff wobei eine Individualisierung in einem ersten Druckwerk stattfindet.

US 2005/167035 A1 offenbart ein Druckverfahren zur Herstellung elektrischer und/oder elektronischer Strukturen auf einem Bedruckstoff wobei zur Herstellung einer Klebstoffstruktur der Bedruckstoff in einem Inkjet Drucker mit einem UV-aktivierbaren Klebstoff bedruckt wird und die Klebstoffstruktur mit einer UV Lampe getrocknet wird.

EP 1 839 903 A2 offenbart ein Verfahren zum Transfer von bildgebenden und/oder ab- oder überdeckenden Applikationsschichten von einer Transferfolie auf Druckbogen in einer Bogen verarbeitenden Maschine, insbesondere einer Bogenrotationsdruckmaschine.

Es ist somit die Aufgabe der vorliegenden Erfindung, ein Verfahren zur Herstellung individualisierter elektrischer und/oder elektronischer Strukturen über ein Kaltfolientransferverfahren bereitzustellen, das die vorgenannten Nachteile des Standes der Technik und die weiteren angesprochenen möglichen Nachteile vermeidet.

Die vorliegende Aufgabe wird gelöst durch ein Druckverfahren nach Anspruch 1 zur Herstellung elektrischer und/oder elektronischer Strukturen auf einem Bedruckstoff, bei dem der Bedruckstoff durch mehrere hintereinander angeordnete Druckwerke einer Druckmaschine bewegt wird, und nachfolgend
i) in mindestens einem ersten Druckwerk ein Sujet der zu druckenden elektrischen und/oder elektronischen Struktur mit mindestens einer Klebestoffkomponente (A)ᵢ auf den Bedruckstoff unter Erzeugung einer Sujet-förmigen Klebstoff-Struktur aufgetragen wird, und
ii) der mit dem Klebstoff partiell bedruckte Bedruckstoff mindestens einem zweiten Druckwerk zugeführt wird, in welchem auf die mit Klebstoff bedruckten Bereiche des Bedruckstoffs mindestens ein leitfähiges Material (B) aufgetragen wird,
wobei
vor Schritt ii) eine individualisierende Modifikation mindestens eines Klebstoffbestandteils erfolgt.

Unter einer "individualisierenden Modifikation mindestens eines Klebstoffbestandteils" ist dabei für den Fall, dass
- in Schritt i) nur eine Klebstoffkomponente (A) aufgetragen wird, ein Schritt der selektiven Bearbeitung der resultierenden Klebstoff-Struktur der Klebstoffkomponente (A)
- und für den Fall, dass in Schritt i) mehrere Klebstoffkomponenten (A)ᵢ aufgetragen werden, ein Schritt der selektiven Bearbeitung einer aus mindestens einer Klebstoffkomponente bestehenden Teil-Struktur (a) oder der Gesamt-Klebstoff-Struktur (A)
zu verstehen, der zu einer Individualisierung der Klebstoff-Strukturen (A) bzw. (a)
- durch einen partiellen Abtrag des Klebstoffs,
- eine partielle chemische Umwandlung und/oder chemische oder physikalische Zerstörung des Klebstoffs bzw. seiner wesentlichen Bestandteile und/oder
- eine Abdeckung bzw. Benetzung durch andere Substanzen
   vor dem Aufbringen des leitfähigen Materials in Schritt ii) führt.

Bevorzugt ist die individualisierende Modifikation mindestens ein chemischer oder physikalischer Bearbeitungsschritt, bevorzugt ein chemischer oder physikalischer Bearbeitungsschritt ausgewählt aus einer Bestrahlung mit elektromagnetischer Strahlung, Inkjet-Bedrucken mit einer modifizierenden Drucktinte, Laser-Bedrucken mit einer Tonersubstanz und einem Stempelverfahren.

Bevorzugt eignet sich eine Bestrahlung mit elektromagnetischer Strahlung für die individualisierende Modifikation von UV-härtenden oder durch UV-Strahlung aktivierbaren Klebstoffbestandteilen. Dazu ist der mindestens eine Klebstoffbestandteil ein UV-härtender oder durch UV-Strahlung aktivierbarer Klebstoffbestandteil und wird vor Schritt ii) selektiv mit einem UV-Strahler, bevorzugt einer UV-LED-Leiste oder einen Laser bestrahlt. Dabei kann bevorzugt die Bestrahlung ausschließlich über die UV-LED-Leiste oder den Laser erfolgen. Alternativ kann auch zunächst die gesamte Struktur des Klebstoffbestandteils mit einem UV-Strahler niederer Leistung zur Vorbehandlung bestrahlt werden, um dann nachfolgend selektiv die ganzflächig vorbehandelte Struktur des Klebstoffbestandteils selektiv zu aktivieren bzw. auszuhärten.

Für diese Verfahrensvariante vorteilhafte einsetzbare UV-Klebstoffe und entsprechende UV-Strahler und Laser sind im Handel erhältlich und können zum Beispiel bei der Firma Hoenle UV Technology oder bei Wellomer Adhesive Technology erworben werden.

Vorteilhaft ist auch ein Verfahren, bei dem der mindestens einen Klebstoffbestandteil selektiv mit einer Drucktinte enthaltend den Klebstoffbestandteil über Inkjet-Druck bedruckt wird, um so eine Individualisierung der Klebstoffstruktur zu erzielen.

Entsprechend für derartige Druckverfahren einsetzbare Klebstoffe sind zum Beispiel Loctite von der Firma Henkel.

Für den Einsatz von Mehrkomponentenklebstoffen eignet sich bevorzugt eine Verfahrensvariante, bei der der mindestens eine Klebstoffbestandteil die erste Komponente eines Zweikomponentenklebstoffs ist, der durch ein Inkjet-Bedrucken mit einer modifizierenden Drucktinte der zweiten, typischerweise als "Aktivator" bezeichneten Komponente des Klebstoffs individualisiert wird. Dazu wird der mindestens eine Klebstoffbestandteil die erste Komponente eines Zweikomponentenklebstoffs über ein Inkjet-Druckverfahren selektiv mit der zweiten Komponente des Klebstoffs bedruckt.

Für diese Verfahrensvariante vorteilhafte einsetzbare Mehrkomponentensysteme existieren ebenfalls von der Firma Henkel, spezielle Varianten, bei denen eine Komponente über ein Ink-Jet Verfahren aufgebracht wird, befinden sich in Entwicklung.

Weiterhin vorteilhaft ist eine Verfahrensvariante, bei der mindestens eine Klebstoffbestandteil ein UV-aktivierbarer Klebstoff ist, der selektiv über Inkjet mit einer modifizierenden Drucktinte bestehend aus einem UV-härtenden Klebstoff oder Lack bedruckt wird. So wird bei einer nachfolgenden Bestrahlung mit einem UV-Strahler gleichzeitig der UV-härtende Klebstoff bzw. Lack ausgehärtet und nur der darunter liegende, nicht bedeckte IV-aktivierbare Klebstoff aktiviert.

Für diese Verfahrensvariante vorteilhafte einsetzbare UV-Klebstoffe und entsprechende UV-Strahler sind im Handel erhältlich und können zum Beispiel bei der Firma Hoenle UV Technology oder bei Wellomer Adhesive Technology erworben werden.

Eine bevorzugte Variante, mit der ein individualisierender Abtrag von Klebstoff bzw. ein individualisierendes Plätten der Klebstoffstruktur erzielt werden kann, ist ein Verfahren, bei dem der mindestens eine Klebstoffbestandteil durch ein individualisierendes Stempelverfahren oder ein Stanzverfahren nachbearbeitet wird.

Eine weitere bevorzugte Verfahrensvariante beruht darauf, dass der mindestens eine Klebstoffbestandteil über ein Druckverfahren, bevorzugt ein Inkjet- oder Laser-Toner-Verfahren, selektiv mit einem Klebstoffbestandteil-adhäsiven Pulver oder einer Klebstoff-benetzenden bzw. Klebstoff-abbauenden Drucktinte bedruckt wird. So wird die Klebeleistung des Klebstoffes durch Bedeckung mit dem Pulver bzw. der Klebstoff-benetzenden Drucktinte abgedeckt und kann nicht mehr klebend wirken, oder er wird alternativ auf typischerweise chemische Reaktion abgebaut.

Bei dem leitfähigen Material, das in Schritt ii) aufgebracht wird, handelt es sich bevorzugt um Metalle, leitfähige Ruße oder Funktionspolymere. Unter einem Funktionspolymer sind dabei Polymere mit halbleitenden oder leitenden Eigenschaften, zu verstehen. Bevorzugt einsetzbare Metalle sind Aluminium, Silber oder Kupfer. Bei bevorzugt einsetzbaren leitfähigen Rußen handelt es sich zum Beispiel um Carbon Black. Bevorzugt einsetzbare Funktionspolymere sind Polythiophene, Polypyrrole, Polyaniline oder Polyethylen-Dioxythiophene.

### Beispiele

Ausführungsbeispiele der Erfindung werden, ohne hierauf beschränkt zu sein, an Hand der beigefügten Zeichnung näher erläutert.

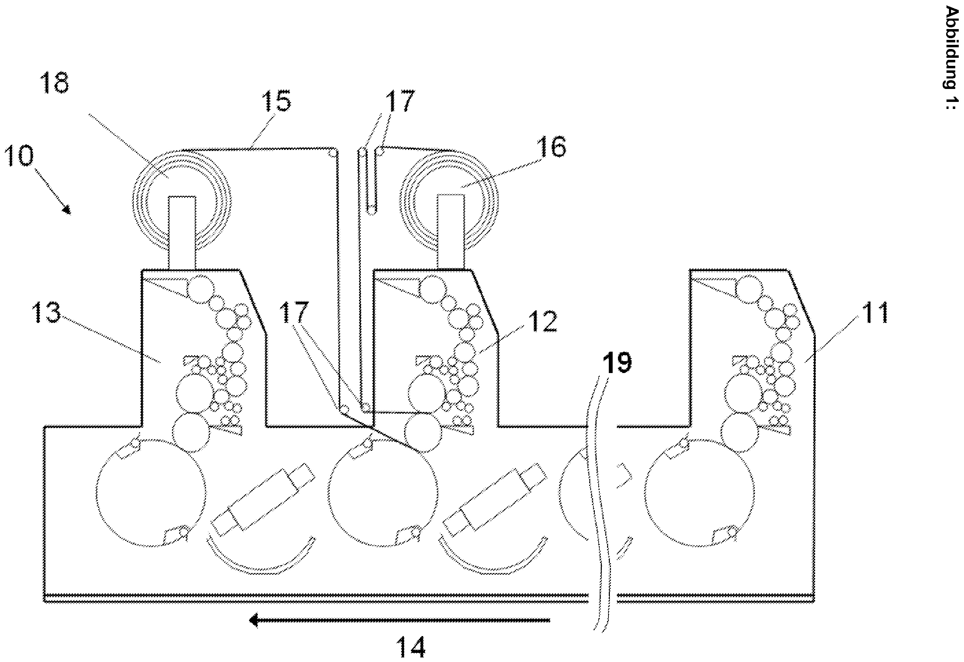

Abbildung 1 zeigt einen Ausschnitt aus einer Druckmaschine zur Verdeutlichung des erfindungsgemäßen Verfahrens zum Personalisieren elektrischer und/oder elektronischer Strukturen. Nachfolgend wird die hier vorliegende Erfindung unter Bezugnahme auf die Abbildung in größerem Detail beschrieben.

Die Abbildung zeigt einen Ausschnitt aus einer Druckmaschine **10** im Bereich von drei hintereinander angeordneten Druckwerken **11**, **12** und **13**, wobei ein zu bedruckender Bedruckstoff in Richtung des Pfeils **14** durch die Druckwerke **11**, **12** und **13** bewegt wird. Optional befindet sich zwischen dem Druckwerk **11** und dem Druckwerk **12** ein weiteres Druckmodul **19**. Mit dem hier vorliegenden erfindungsgemäßen Verfahren soll eine individualisierte elektronische bzw. elektrische Struktur auf den Bedruckstoff aufgetragen werden.

Im Sinne der hier vorliegenden Erfindung wird vorgeschlagen, in mindestens einem ersten Druckwerk, im Ausführungsbeispiel der Abbildung im Druckwerk **11**, ein Precursorbild der zu druckenden, elektrischen und/oder elektronischen Struktur mit einem Kleber auf den Bedruckstoff aufzutragen.

Darauffolgend wird der mit Klebstoff oder einem Klebstoffprecursor partiell bedruckte Bedruckstoff mindestens einem weiteren Druckwerk **19** zugeführt, in dem der partiell bedruckte Bedruckstoff so modifiziert wird, dass die klebenden Bereiche individualisierte Informationen enthalten. Das zusätzliche Druckwerk **19** kann beispielsweise eine Leiste aus UV-Leuchtdioden sein, es kann sich aber auch um ein Ink-Jet Modul, ein Laserdruckwerk, ein Rotationsstempeldruckverfahren oder eine beliebiges anderes Digitaldruckverfahren handeln.

Daraufhin wird der Bedruckstoff mindestens einem zweiten Druckwerk, im Ausführungsbeispiel der Abbildung dem Druckwerk **12**, zugeführt. In diesem zweiten Druckwerk **12** wird dann auf die klebenden Bereiche des Bedruckstoffs ein leitfähiges Material aufgetragen. Im Sinne der hier vorliegenden Erfindung wird der Klebstoff im ersten Druckwerk **11** vorzugsweise im Offsetdruck aufgetragen. In diesem Fall ist das erste Druckwerk **11** als Offset-Druckwerk ausgebildet. Alternativ hierzu ist es auch möglich, dass das erste Druckwerk **11** als direktes oder indirektes Hochdruckwerk ausgebildet ist, um so den Klebstoff im direkten oder indirekten Hochdruck auf den Bedruckstoff aufzutragen. Wie in der Abbildung dargestellt, wird nach einer besonders bevorzugten Ausführungsform der hier vorliegenden Erfindung der mit dem Klebstoff partiell bedruckte Bedruckstoff in dem zweiten Druckwerk **12** einer Folie **15** zugeführt. Die Folie **15** trägt ein elektrisch leitfähiges bzw. ein elektrisch halbleitfähiges Material, welches von der Folie **15** auf die mit Klebstoff bedruckten Bereiche des Bedruckstoffs übertragen wird. Wie der Abbildung entnommen werden kann, wird die Folie **15** von einer ersten Trommel **16** abgewickelt, über mehrere Umlenkwalzen **17** dem Bedruckstoff zugeführt und nach dem Übertragen des leitfähigen Materials auf die mit Klebstoff bedruckten Bereiche des Bedruckstoffs auf einer Trommel **18** aufgewickelt. Auf der Trommel **16** liegt demnach eine vollständig bzw. komplett mit leitfähigem Material beschichtete Folie vor, wohingegen auf der Trommel **18** das leitfähige Material bereichsweise von der Folie **15** auf den Bedruckstoff übertragen wurde. Bei der auf der Trommel **18** aufgewickelten Folie handelt es sich demnach um "verbrauchte" Folie. Im Anschluss an das Auftragen des leitfähigen Materials auf die mit Klebstoff bedruckten Bereiche des Bedruckstoffs wird der Bedruckstoff dem Druckwerk **13** zugeführt.

### Beispiel 1:

Es liegt im Sinne der vorliegenden Erfindung, einen Kleber zu benutzen, der mittels UV-Bestrahlung aktiviert wird. Solche Kleber sind in der Drucktechnik gut bekannt. Dabei wird in mindestens einem ersten Druckwerk, im Ausführungsbeispiel der Abbildung im Druckwerk 11, ein Precursorbild der zu druckenden, elektrischen und/oder elektronischen Struktur mit einem Kleber auf den Bedruckstoff aufgetragen.

Darauffolgend wird der mit dem UV-aktivierbaren Klebstoff partiell bedruckte Bedruckstoff mindestens einem weiteren Druckwerk **19** zugeführt, in dem sich eine Leiste aus UV-Leuchtdioden befindet. Diese aktiviert nun durch selektive partielle oder flächige UV-Bestrahlung die Bereiche des Klebers, die im folgenden Druckwerk mittels des Folienübertrages das individualisierte Bild ergeben sollen.

Daraufhin wird der Bedruckstoff mindestens einem zweiten Druckwerk, im Ausführungsbeispiel der Abbildung dem Druckwerk **12,** zugeführt. In diesem zweiten Druckwerk **12** wird dann auf die klebenden Bereiche des Bedruckstoffs ein leitfähiges Material aufgetragen. Sollte die Intensität der Bestrahlung nicht ausreichen, den Klebstoff ausreichend zu aktivieren, ist es ebenfalls im Sinne der Erfindung, vor oder nach der UV-LED-Leiste in **19** den gesamten Kleber flächig mit einer weiteren UV-Quelle so zu bestrahlen, dass nur die bestrahlten Bereiche beim Folientransfer mit Folie bedeckt werden.

Es liegt ebenso im Sinne der Erfindung, einen Kleber zu verwenden, der mittels UV-Licht ausgehärtet werden kann. Der oben beschriebene Prozess kann dann so verwendet werden, dass durch die selektive Bestrahlung im Bereich **19** der Kleber deaktiviert wird, und nur unbelichtete Bereiche im Druckwerk **12** mit Folie bedeckt werden.

### Beispiel 2:

Es liegt ebenfalls im Sinne der vorliegenden Erfindung, einen Zwei-Komponenten-Kleber zu benutzen. Dabei wird in mindestens einem ersten Druckwerk, im Ausführungsbeispiel der Abbildung im Druckwerk **11**, ein Precursorbild der zu druckenden Struktur mit einem der ersten Komponente des Klebers auf den Bedruckstoff aufgetragen.

Darauffolgend wird der partiell bedruckte Bedruckstoff mindestens einem weiteren Druckwerk **19** zugeführt, in dem sich ein Inkjet Druckmodul oder eine anderes Digitaldruckverfahren befindet. Dieses beschichtet nun selektiv partiell oder flächig die Bereiche mit der zweiten Komponente des zwei-komponentenklebers, die im folgenden Druckwerk mittels des Folienübertrages das individualisierte Bild ergeben sollen. Daraufhin wird der Bedruckstoff mindestens einem zweiten Druckwerk, im Ausführungsbeispiel der Abbildung dem Druckwerk **12,** zugeführt. In diesem zweiten Druckwerk **12** wird dann auf die klebenden Bereiche des Bedruckstoffs ein leitfähiges Material aufgetragen.

### Beispiel 3:

Eine weitere Anwendung der vorliegenden Erfindung ist im Folgenden beschrieben: Es wird in mindestens einem ersten Druckwerk, im Ausführungsbeispiel der Abbildung im Druckwerk **11,** ein Precursorbild der zu druckenden Struktur mit einem Kleber auf den Bedruckstoff aufgetragen.

Darauffolgend wird der partiell bedruckte Bedruckstoff mindestens einem weiteren Druckwerk **19** zugeführt, in dem sich ein Inkjet Druckmodul oder eine anderes Digitaldruckverfahren befindet. Dieses beschichtet nun partiell einzelne Bereiche, die zuvor mit Kleber versehen wurden, mit einem Deaktivator, z.B. einem Pulver so, dass der Kleber an diesen Stellen nicht mehr über eine ausreichende Klebewirkung verfügt. Daraufhin wird der Bedruckstoff mindestens einem zweiten Druckwerk, im Ausführungsbeispiel der Abbildung dem Druckwerk **12,** zugeführt. In diesem zweiten Druckwerk **12** wird dann auf die klebenden Bereiche des Bedruckstoffs ein leitfähiges Material aufgetragen.

Es liegt ebenso im Sinne der Erfindung, nach dem Auftrag des Klebers im Druckwerk **11,** den partiell bedruckten Bedruckstoff mindestens einem weiteren Druckwerk **19** zuzuführen, in dem sich ein Inkjet Druckmodul oder eine anderes Digitaldruckverfahren befindet. In diesem wird mittels des Digitaldruckverfahrens zusätzlicher Kleber aufgebracht, so dass ein erweitertes, klebendes Druckbild entsteht. Daraufhin wird der Bedruckstoff mindestens einem zweiten Druckwerk, im Ausführungsbeispiel der Abbildung dem Druckwerk **12,** zugeführt. In diesem zweiten Druckwerk **12** wird dann auf die klebenden Bereiche des Bedruckstoffs ein leitfähiges Material aufgetragen.

### Beispiel 4:

Eine weitere Anwendung der vorliegenden Erfindung ist im Folgenden beschrieben: Es wird in mindestens einem ersten Druckwerk, im Ausführungsbeispiel der Abbildung im Druckwerk 11, ein Precursorbild der zu druckenden Struktur mit einem Kleber, zum Beispiel einem UV-aktivierbaren Kleber, auf den Bedruckstoff aufgetragen.

Darauffolgend wird der partiell bedruckte Bedruckstoff mindestens einem weiteren Druckwerk **19** zugeführt, in dem sich ein Inkjet Druckmodul oder ein anderes Digitaldruckverfahren befindet. Dieses beschichtet nun partiell einzelne Bereiche, die zuvor mit Kleber versehen wurden, mit einem UV härtenden Lack. Anschließend wird der gesamte Bogen flächig mit UV-Licht bestrahlt. Die Bereiche mit dem Kleber werden oder bleiben klebend, während die Bereiche mit dem UV härtenden Lack für den folgenden Folienübertrag deaktiviert werden. Daraufhin wird der Bedruckstoff mindestens einem zweiten Druckwerk, im Ausführungsbeispiel der Abbildung dem Druckwerk **12,** zugeführt. In diesem zweiten Druckwerk **12** wird dann auf die klebenden Bereiche des Bedruckstoffs ein leitfähiges Material aufgetragen.

## Patentansprüche

1. Druckverfahren zur Herstellung elektrischer und/oder elektronischer Strukturen, auf einem Bedruckstoff, bei dem der Bedruckstoff durch mehrere hintereinander angeordnete Druckwerke einer Druckmaschine bewegt wird, und nachfolgend
i) in mindestens einem ersten Druckwerk ein Sujet der zu druckenden elektrischen und/oder elektronischen Struktur mit mindestens einer Klebestoffkomponente (A)ᵢ auf den Bedruckstoff unter Erzeugung einer Sujet-förmigen Klebstoff-Struktur aufgetragen wird, und
ii) der mit dem Klebstoff partiell bedruckte Bedruckstoff mindestens einem zweiten Druckwerk zugeführt wird, in welchem auf die mit Klebstoff bedruckten Bereiche des Bedruckstoffs mindestens ein leitfähiges Material (B) aufgetragen wird,
**dadurch gekennzeichnet,**
**dass** vor Schritt ii) eine individualisierende Modifikation mindestens eines Klebstoffbestandteils erfolgt, mit der Maßgabe, dass unter einer individualisierenden Modifikation mindestens eines Klebstoffbestandteils für den Fall, dass in Schritt i) nur eine Klebstoffkomponente (A) aufgetragen wird, ein Schritt der selektiven Bearbeitung der resultierenden Klebstoff-Struktur der Klebstoffkomponente (A),
und für den Fall, dass in Schritt i) mehrere Klebstoffkomponenten (A)ᵢ aufgetragen werden, ein Schritt der selektiven Bearbeitung einer aus mindestens einer Klebstoffkomponente bestehenden Teil-Struktur (a) oder der Gesamt-Klebstoff-Struktur (A),
zu verstehen ist, der zu einer Individualisierung der Klebstoff-Strukturen (A) bzw. (a)
durch einen partiellen Abtrag des Klebstoffs,
durch eine partielle chemische Umwandlung und/oder chemische oder physikalische Zerstörung des Klebstoffs bzw. seiner wesentlichen Bestandteile und/oder
durch eine Abdeckung bzw. Benetzung durch andere Substanzen vor dem Aufbringen des leitfähigen Materials in Schritt ii) führt.

2. Druckverfahren nach Anspruch 1,
**dadurch gekennzeichnet,**
**dass** die individualisierende Modifikation des mindestens einen Klebstoffbestandteils durch mindestens einen chemischen oder physikalischen Bearbeitungsschritt erfolgt.

3. Druckverfahren nach Anspruch 2,
**dadurch gekennzeichnet,**
**dass** der chemische oder physikalische Bearbeitungsschritt ausgewählt ist aus einer Bestrahlung mit elektromagnetischer Strahlung, Inkjet-Bedrucken mit einer modifizierenden Drucktinte, Laser-Bedrucken mit einer Tonersubstanz und einem Stempelverfahren.

4. Druckverfahren nach Anspruch 3,
**dadurch gekennzeichnet,**
**dass** der mindestens eine Klebstoffbestandteil ein UV-härtender oder durch UV-Strahlung aktivierbarer Klebstoffbestandteil ist und vor Schritt ii) selektiv mit einem UV-Strahler, bevorzugt einer UV-LED-Leiste oder einem Laser bestrahlt wird.

5. Druckverfahren nach Anspruch 3,
**dadurch gekennzeichnet,**
**dass** der mindestens eine Klebstoffbestandteil selektiv mit einer Drucktinte enthaltend den Klebstoffbestandteil über Inkjet-Druck bedruckt wird.

6. Druckverfahren nach Anspruch 3,
**dadurch gekennzeichnet,**
**dass** der mindestens eine Klebstoffbestandteil die erste Komponente eines Zweikomponentenklebstoffs ist, der über ein Inkjet-Druckverfahren selektiv mit der zweiten Komponente des Klebstoffs bedruckt wird.

7. Druckverfahren nach Anspruch 3,
**dadurch gekennzeichnet,**
**dass** der mindestens eine Klebstoffbestandteil ein UV-aktivierbarer Klebstoff ist, der selektiv über Inkjet mit einer modifizierenden Drucktinte bestehend aus einem UV-härtenden Klebstoff oder Lack bedruckt und nachfolgend mit einem UV-Strahler bestrahlt wird.

8. Druckverfahren nach Anspruch 3,
**dadurch gekennzeichnet,**
**dass** der mindestens eine Klebstoffbestandteil durch ein individualisierendes Stempel- oder Stanzverfahren nachbearbeitet wird.

9. Druckverfahren nach Anspruch 3,
**dadurch gekennzeichnet,**
**dass** der mindestens eine Klebstoffbestandteil über ein Druckverfahren selektiv mit einem Klebstoffbestandteil-adhäsiven Pulver oder einer Klebstoff-benetzenden bzw. Klebstoff-abbauenden Drucktinte bedruckt wird.

10. Druckverfahren nach einem der vorhergehenden Ansprüche,
**dadurch gekennzeichnet,**
**dass** das mindestens eine in Schritt ii) aufzubringende Material ein Metall, ein leitfähiges Ruß oder ein Funktionspolymer ist.

## Claims

1. Printing method for producing electrical and/or electronic structures on a print medium, wherein the print medium is moved through a plurality of successively disposed printing units of a printing machine, and subsequently
i) in at least one first printing unit, a subject of the electrical and/or electronic structure to be printed is applied with at least one adhesive component (A)ᵢ to the print medium, to generate a subject-shaped adhesive structure and
ii) the print medium partially printed with the adhesive is supplied to at least one second printing unit, in which at least on conductive material (B) is applied to the adhesive-printed regions of the print medium,
**characterized**
**in that** before step ii) there is an individualizing modification of at least one adhesive constituent, with the proviso that an individualizing modification of at least one adhesive constituent means, for the case where in step i) only one adhesive component (A) is applied, a step of selective processing of the resulting adhesive structure of the adhesive component (A), and
in the case where in step i) a plurality of adhesive components (A)ᵢ are applied, a step of selective processing of a sub-structure (a) consisting of at least one adhesive component, or of the entire adhesive structure (A),
which leads to individualization of the adhesive structures (A) or (a)
by partial depletion of the adhesive,
by partial chemical conversion and/or chemical or physical destruction of the adhesive and/or of its essential constituents, and/or
by masking and/or wetting by other substances before the application of the conductive material in step ii).

2. Printing method according to Claim 1,
**characterized**
**in that** the individualizing modification of the at least one adhesive constituent takes place by at least one chemical or physical processing step.

3. Printing method according to Claim 2,
**characterized**
**in that** the chemical or physical processing step is selected from irradiation with electromagnetic radiation, inkjet printing with a modifying printing ink, laser printing with a toner substance, and a die process.

4. Printing method according to Claim 3,
**characterized**
**in that** the at least one adhesive constituent is a UV-curing adhesive constituent or an adhesive constituent which can be activated by UV radiation, and before step ii) irradiation is carried out selectively with a UV lamp, preferably with a UV-LED strip or with a laser.

5. Printing method according to Claim 3,
**characterized**
**in that** the at least one adhesive constituent is printed selectively via inkjet printing with a printing ink comprising the adhesive constituent.

6. Printing method according to Claim 3,
**characterized**
**in that** the at least one adhesive constituent is the first component of a two-component adhesive which is printed selectively via an inkjet printing method with the second component of the adhesive.

7. Printing method according to Claim 3,
**characterized**
**in that** the at least one adhesive constituent is a UV-activatable adhesive which is printed selectively via inkjet with a modifying printing ink consisting of a UV-curing adhesive or varnish and is subsequently irradiated with a UV lamp.

8. Printing method according to Claim 3,
**characterized**
**in that** the at least one adhesive constituent is worked on subsequently by means of an individualizing die or stamping process.

9. Printing method according to Claim 3,
**characterized**
**in that** the at least one adhesive constituent is printed via a printing process selectively with a powder adhesive to adhesive constituent or with a printing ink which wets adhesive and/or which breaks down adhesive.

10. Printing method according to any of the preceding claims,
**characterized**
**in that** the at least one material for application in step ii) is a metal, a conductive carbon black or a functional polymer.

## Revendications

1. Procédé d'impression pour la fabrication de structures électriques et/ou électroniques sur un support, selon lequel le support est déplacé au travers de plusieurs imprimantes agencées en série d'une machine d'impression, puis
i) dans au moins une première imprimante, un sujet de la structure électrique et/ou électronique à imprimer est appliqué avec au moins un composant adhésif (A)ᵢ sur le support pour former une structure d'adhésif ayant la forme du sujet, et
ii) le support partiellement imprimé avec l'adhésif est introduit dans au moins une deuxième imprimante, dans laquelle au moins un matériau conducteur (B) est appliqué sur les zones imprimées avec l'adhésif du support, **caractérisé en ce qu'**une modification d'individualisation d'au moins un constituant adhésif a lieu avant l'étape ii), à condition que, pour une modification d'individualisation d'au moins un constituant adhésif,
lorsqu'à l'étape i) uniquement un composant adhésif (A) est appliqué, une étape de traitement sélectif de la structure d'adhésif résultante du composant adhésif (A) est à comprendre,
et lorsqu'à l'étape i) plusieurs composants adhésifs (A)ᵢ sont appliqués, une étape de traitement sélectif d'une structure partielle (a) constituée par au moins un composant adhésif ou de la structure d'adhésif totale (A) est à comprendre,
qui conduit à une individualisation des structures d'adhésif (A) ou (a)
par une élimination partielle de l'adhésif,
par une transformation chimique partielle et/ou une décomposition chimique ou physique de l'adhésif ou de ses constituants essentiels et/ou
par un recouvrement ou un mouillage par d'autres substances avant l'application du matériau conducteur à l'étape ii).

2. Procédé d'impression selon la revendication 1, **caractérisé en ce que** la modification d'individualisation de l'au moins un constituant adhésif a lieu par au moins une étape de traitement chimique ou physique.

3. Procédé d'impression selon la revendication 2, **caractérisé en ce que** l'étape de traitement chimique ou physique est choisie parmi une exposition à un rayonnement électromagnétique, une impression jet d'encre avec une encre d'impression modifiante, une impression laser avec une substance toner et un procédé de poinçonnage.

4. Procédé d'impression selon la revendication 3, **caractérisé en ce que** l'au moins un constituant adhésif est un constituant adhésif durcissant par UV ou activable par un rayonnement UV, et est exposé sélectivement à un rayonnement par un émetteur d'UV, de préférence une barre UV-LED, ou un laser avant l'étape ii).

5. Procédé d'impression selon la revendication 3, **caractérisé en ce que** l'au moins un constituant adhésif est imprimé sélectivement avec une encre d'impression contenant le constituant adhésif par impression jet d'encre.

6. Procédé d'impression selon la revendication 3, **caractérisé en ce que** l'au moins un constituant adhésif est le premier composant d'un adhésif bicomposant, qui est imprimé sélectivement par un procédé d'impression jet d'encre avec le deuxième composant de l'adhésif.

7. Procédé d'impression selon la revendication 3, **caractérisé en ce que** l'au moins un constituant adhésif est un adhésif activable par UV, qui est imprimé sélectivement par jet d'encre avec une encre d'impression modifiante constituée par un adhésif ou un vernis durcissant par UV, puis exposé à un rayonnement UV.

8. Procédé d'impression selon la revendication 3, **caractérisé en ce que** l'au moins un constituant adhésif est post-traité par un procédé de poinçonnage ou d'estampage individualisant.

9. Procédé d'impression selon la revendication 3, **caractérisé en ce que** l'au moins un constituant adhésif est imprimé sélectivement par un procédé d'impression avec une poudre adhérant aux constituants adhésifs ou une encre d'impression mouillant l'adhésif ou décomposant l'adhésif.

10. Procédé d'impression selon l'une quelconque des revendications précédentes, **caractérisé en ce que** l'au moins un matériau à appliquéer à l'étape ii) est un métal, un noir de carbone conducteur ou un polymère fonctionnel.
